# FASCICULE DE BREVET EUROPEEN

(11) **EP 3 451 340 B1**
(45) Date de publication et mention de la délivrance du brevet: **23.12.2020**
(21) Numéro de dépôt: 18191912.7
(22) Date de dépôt: 31.08.2018
(51) Int. Cl.: G11C 11/404, G11C 11/409, H01L 27/108

(54) **PROCÉDÉ DE PROGRAMMATION D'UNE CELLULE MÉMOIRE DRAM À UN TRANSISTOR ET DISPOSITIF MÉMOIRE**
PROGRAMMIERUNGSVERFAHREN EINER DRAM-SPEICHERZELLE MIT EINEM TRANSISTOR, UND SPEICHERVORRICHTUNG
METHOD FOR PROGRAMMING A DRAM MEMORY CELL WITH A TRANSISTOR AND MEMORY DEVICE

(30) Priorité: 04.09.2017 FR 1758122
(43) Date de publication de la demande: 06.03.2019
(73) Titulaire: Commissariat à l'Energie Atomique et aux Energies Alternatives, 75015 Paris (FR)
(72) Inventeur: LACORD, Joris, 38140 SAINT BLAISE DU BUIS (FR); TCHEME WAKAM, François, 38400 SAINT-MARTIN-D'HERES (FR)
(74) Mandataire: Cabinet Camus Lebkiri

(56) Documents cités:
- US-A1- 2011 042 746
- US-A1- 2013 148 441
- JIN-WOO HAN ET AL: "A Bulk FinFET Unified-RAM (URAM) Cell for Multifunctioning NVM and Capacitorless 1T-DRAM", IEEE ELECTRON DEVICE LETTERS, IEEE SERVICE CENTER, NEW YORK, NY, US, vol. 29, no. 6, 1 juin 2008 (2008-06-01), pages 632-634, XP011215166, ISSN: 0741-3106
- NOEL RODRIGUEZ ET AL: "Novel Capacitorless 1T-DRAM Cell for 22-nm Node Compatible With Bulk and SOI Substrates", IEEE TRANSACTIONS ON ELECTRON DEVICES, IEEE SERVICE CENTER, PISACATAWAY, NJ, US, vol. 58, no. 8, 1 août 2011 (2011-08-01), pages 2371-2377, XP011336295, ISSN: 0018-9383, DOI: 10.1109/TED.2011.2147788
- NOEL RODRIGUEZ ET AL: "New concepts for IT-DRAMs: Overcoming the scaling limits", SEMICONDUCTOR CONFERENCE (CAS), 2011 INTERNATIONAL, IEEE, 17 octobre 2011 (2011-10-17), pages 11-14, XP032069132, DOI: 10.1109/SMICND.2011.6095698 ISBN: 978-1-61284-173-1

## Description

### DOMAINE TECHNIQUE

La présente invention est relative aux mémoires vives dynamiques, aussi connues sous l'acronyme « DRAM » (pour « Dynamic Random Access Memory » en anglais). L'invention concerne plus particulièrement un procédé de programmation d'une cellule de mémoire DRAM à un transistor (1T-DRAM).

### ÉTAT DE LA TECHNIQUE

Les cellules de mémoire DRAM sont classiquement constituées d'un transistor MOS et d'un condensateur. Malgré cette structure simple, les cellules de mémoire DRAM sont difficile à miniaturiser, la difficulté résidant principalement dans la diminution de la taille des condensateurs. Pour s'affranchir de cette difficulté, des cellules mémoire constituées d'un unique transistor, sans condensateur, ont été élaborées, le transistor MOS étant à corps isolé par jonction ou à corps isolé par isolant dans des technologies de type semi-conducteur sur isolant (SOI, pour « Semiconductor On Insulator » en anglais) ou semi-conducteur sur rien (SON ou « Semiconductor On Nothing »). Dans ces cellules mémoire dites « 1T-DRAM », la fonction de mémorisation correspond à un stockage de charges dans le corps du transistor.

Les cellules mémoire 1T-DRAM souffrent pour la plupart d'inconvénients considérables, parmi lesquels on peut citer une durée de rétention limitée, une consommation élevée, une faible différenciation entre les deux états de mémorisation, une faible vitesse de fonctionnement, l'impossibilité de réduire l'épaisseur du corps du transistor qui doit assurer la présence simultanée des deux types de porteurs de charge (électrons et trous), et/ou les difficultés de fabrication.

L'architecture de cellule mémoire « A2RAM », décrite dans le brevet FR2958779 et l'article [« Novel Capacitorless 1T-DRAM Cell for 22-nm Node Compatible With Bulk and SOI Substrates », N. Rodriguez et al., IEEE Transactions on Electron Devices, Volume 58, Issue 8, 2011], se distingue au contraire par une consommation maitrisée, une large fenêtre de programmation, une commande simple et l'absence de super-couplage, c'est-à-dire l'impossibilité d'avoir les deux types de porteurs de charge dans un couche mince de silicium (typiquement d'épaisseur inférieure à 20 nm).

La publication scientifique titrée "A Bulk FinFet Unified-RAM (URAM) Cell for Multifunctioning NVM and Capacitorless 1T-DRAM" par Jin-Woo Han et al., IEEE Electron Device Letters [Volume 29, Issue 6, Juin 2008] divulgue une cellule de mémoire vive dite unifiée intégrant une fonctionnalité de mémoire non volatile et une fonctionnalité de mémoire dynamique dans un seul transistor.

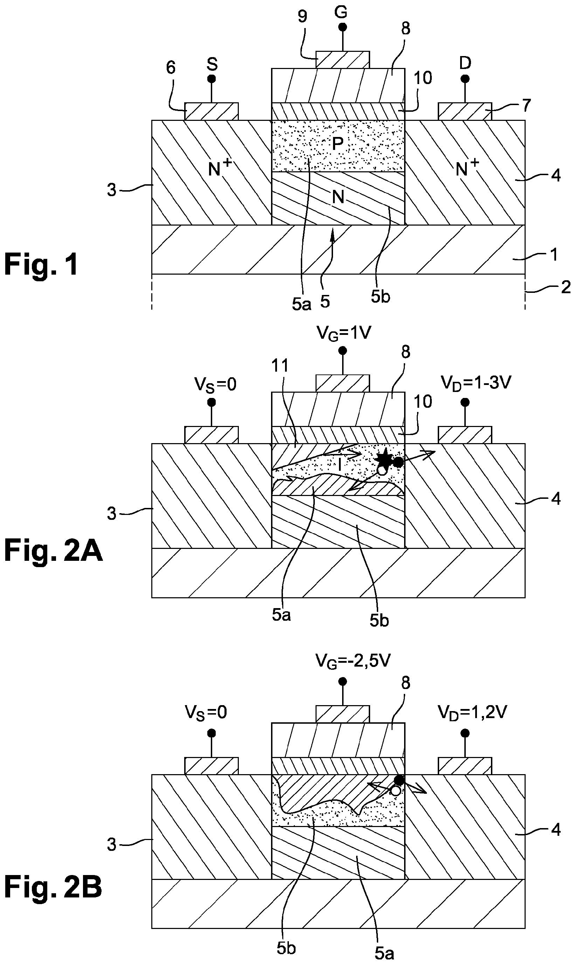

La figure 1 est une vue en coupe représentant schématiquement une cellule mémoire de type A2RAM.

La cellule mémoire A2RAM est constituée d'un transistor MOS reposant sur une couche isolante 1, typiquement la couche d'oxyde enterrée d'un substrat 2 de type SOI. De façon classique, le transistor MOS comprend une région de source 3 et une région de drain 4 fortement dopées d'un premier type de conductivité, par exemple de type N, et séparées par une région de corps 5. Les régions de source 3 et de drain 4 sont respectivement en contact avec des métallisations de source 6 et de drain 7, reliées respectivement à des bornes de source S et de drain D. La région de corps 5 est surmontée d'une grille 8 reliée à une borne de grille G par l'intermédiaire d'une métallisation de grille 9. La grille 8 est isolée électriquement de la région de corps 5 par une couche diélectrique 10, typiquement un oxyde de grille.

La particularité de ce transistor MOS est que la région de corps 5 est divisée dans son épaisseur en une région de corps supérieure 5a du côté de la grille 8 et une région de corps inférieure 5b au voisinage de la couche isolante 1. La région de corps supérieure 5a, appelée également « région de canal » ou « nœud de stockage », est légèrement dopée d'un second type de conductivité opposé au premier type, soit de type P dans cet exemple. La région de corps inférieure 5b est dopée du même type de conductivité que les régions de source et de drain 3-4, soit de type N. Elle est communément appelée « pont conducteur » puisqu'elle relie, en l'absence de polarisation sur la grille, la source 3 et le drain 4 électriquement.

Le principe de fonctionnement de cette cellule mémoire est le suivant. Un bit d'information est mémorisé en contrôlant la quantité de porteurs de charge majoritaires stockés dans la région de corps supérieure 5a. Ainsi, on distingue deux états de mémorisation : l'état logique '1' lorsque la région de corps supérieure 5a contient des porteurs de charge majoritaires (des trous dans le cas d'une région de corps supérieure 5a dopée de type P) et l'état logique '0' lorsque la région de corps supérieure 5a est vide de porteurs de charge majoritaires.

L'information stockée dans la cellule mémoire est lue en mesurant le courant qui circule dans la résistance formée par la source 3, la région de corps inférieure 5b et le drain 4 (tous trois dopés de type N). Pour cela, on applique un potentiel négatif sur la grille 8 et un potentiel faiblement positif sur le drain 4. Dans le cas où un état '0' a été programmé, c'est-à-dire qu'aucune charge n'est stockée dans la région de corps supérieure 5a, aucun courant ne circule dans la région de corps supérieure 5a car le transistor est bloqué (il n'y a donc pas formation du canal de conduction). Par ailleurs, le potentiel négatif de la grille 8 déplète la région de corps inférieure 5b qui ne laisse donc pas passer de courant. Par contre, lorsque l'état '1' a été programmé, les charges positives stockées dans la région de corps supérieure 5a font écran au potentiel négatif de la grille 8 et un courant d'électrons circule dans la région (non déplétée) de corps inférieure 5b.

Il existe deux manières de programmer la cellule mémoire A2RAM dans l'état '1'. Celles-ci reposent sur des phénomènes physiques distincts pour générer les porteurs de charge majoritaires : l'ionisation par impact (II) dans la région de corps supérieure 5a et l'effet tunnel bande à bande (« Band-to-band tunneling » en anglais) entre le drain 4 et la région de corps supérieure 5a.

La figure 2A représente schématiquement l'écriture d'un '1' dans la cellule mémoire de la figure 1 (transistor NMOS) par ionisation par impact dans la région de corps supérieure 5a. Un potentiel V_{D} positif relativement élevé, par exemple de 1 V à 3 V, est appliquée sur le drain 4 du transistor, tandis que la grille 8 est portée à un potentiel V_{G} positif (typiquement 1 V). La source 3 du transistor est en permanence connectée à un potentiel de référence, en général nul par souci de simplicité. Ces potentiels ont pour effet de polariser le transistor dans l'état passant, et plus particulièrement en régime de saturation. Ainsi, un canal de conduction 11 se forme dans la région de corps supérieure 5a et un courant d'électrons I circule de la source 3 vers le drain 4. Étant donné que la différence de potentiels entre la source 3 et le drain 4 est relativement élevée, un fort champ électrique règne dans la zone de pincement du canal de conduction 11. Sous l'effet de ce champ électrique, des électrons en circulation créent par impact des paires électron-trou dans la région de corps supérieure 5a. Les électrons créés sont recueillis par le drain 4 et contribuent au courant de drain I, tandis que les trous demeurent dans la région de corps supérieure 5a, piégés par les barrières de potentiel dues aux jonctions PN entre la source 3 et la région de corps supérieure 5a, entre le drain 4 et la région de corps supérieure 5a, et entre la région de corps supérieure 5a et la région de corps inférieure 5b.

Ce premier mode de programmation présente l'avantage d'être rapide (temps de programmation de l'ordre de la dizaine de nanosecondes), au détriment d'une forte consommation électrique. Par ailleurs, le fort champ électrique qui règne dans la zone de pincement du canal 11 est à l'origine de problèmes de rétention de l'information et de fiabilité du transistor. Des électrons soumis au champ électrique sont en effet piégés dans l'oxyde de grille 10, ce qui peut conduire à une défaillance de la cellule mémoire.

La figure 2B illustre de façon schématique l'écriture d'un '1' dans la même cellule mémoire par effet tunnel bande à bande. Dans ce deuxième mode de programmation, le transistor est polarisé dans l'état bloqué. Un potentiel V_{G} fortement négatif, compris entre -2,5 V et -3 V, est appliqué sur la grille 8 pendant que le drain 4 est porté à un potentiel V_{D} positif, par exemple de 1,2 V. Le potentiel appliqué sur la source 3 est toujours nul. Cette polarisation du transistor modifie le diagramme de bandes d'énergie entre le drain 4 et la région de corps supérieure 5a, autorisant ainsi le passage, par effet tunnel, de trous de la bande de conduction du drain 4 vers la bande de valence de la région de corps supérieure 5a (et le passage d'électrons de la bande de valence de la région 5a vers la bande de conduction du drain 4).

Contrairement au premier mode de programmation (ionisation par impact), la programmation par effet tunnel band à bande est peu consommatrice d'énergie, car le transistor est à l'état « off » pendant l'écriture. Le temps de programmation par effet tunnel band à bande est par contre bien plus long, de l'ordre de 1 µs pour les valeurs de potentiels susmentionnées. La génération de trous par effet tunnel bande-à-bande est d'autant plus importante que le champ électrique dans la région de corps supérieure 5a est élevé. Ainsi, pour atteindre un temps de programmation comparable à celui de l'ionisation par impact, il faudrait augmenter fortement la tension drain-grille afin de maximiser le champ électrique.

Ainsi, avec les modes de programmation classiques, on constate qu'il est impossible de concilier une vitesse de programmation élevée et une consommation électrique faible.

### RÉSUMÉ DE L'INVENTION

Il existe par conséquent un besoin de prévoir un procédé de programmation d'une cellule mémoire à un transistor de type A2RAM, qui soit à la fois rapide et économe en énergie. La cellule mémoire A2RAM comporte une source et un drain dopés d'un premier type de conductivité, une région de corps disposée entre la source et le drain, et une grille isolée disposée en regard de la région de corps. La région de corps comporte des première et deuxième portions s'étendant parallèlement à la grille isolée entre la source et le drain, la première portion étant dopée d'un second type de conductivité opposé et disposée entre la grille isolée et la deuxième portion, dopée du premier type de conductivité.

Selon l'invention, on tend à satisfaire ce besoin en prévoyant une étape de polarisation du transistor dans un état bloqué au moyen de potentiels électriques appliqués sur le drain et la grille, le potentiel du drain et le potentiel de la grille étant choisis de manière à créer des porteurs de charge par ionisation par impact dans la deuxième portion de la région de corps.

Ainsi, le procédé de programmation selon l'invention diffère du mode de programmation classique par ionisation par impact en ce que le transistor est dans l'état bloqué (et non en régime de saturation) et en ce que l'ionisation par impact a lieu dans la deuxième portion (au lieu de la première portion).

Par ailleurs, le procédé de programmation selon l'invention et le mode de programmation classique par effet tunnel band à bande ont en commun le fait que le transistor est polarisé dans l'état bloqué. Il ne s'agit toutefois pas du même mécanisme à l'origine de la majorité des porteurs de charge. En effet, dans le procédé de programmation selon l'invention, les porteurs de charge sont essentiellement créés par ionisation par impact dans la deuxième portion. La génération des porteurs de charge par ionisation par impact étant plus rapide que par effet tunnel bande à bande, le procédé de programmation selon l'invention allie une vitesse de programmation élevée à une faible consommation électrique (état bloqué du transistor).

Les potentiels de polarisation nécessaires pour obtenir des ionisations par impact dans la deuxième portion varient en fonction des dimensions du transistor, par exemple de la longueur de grille ou de l'épaisseur de la région de corps. On observe néanmoins que le potentiel de grille appliqué dans le procédé de programmation selon l'invention est inférieur en valeur absolue à celui appliqué habituellement lors d'une programmation classique par effet tunnel bande à bande. La cellule mémoire peut donc fonctionner avec des tensions plus faibles qu'auparavant, ce qui simplifie l'intégration de la mémoire et élargit son champ d'applications à de nouveaux domaines, comme les objets connectés.

Le potentiel de la grille peut être compris entre 0,5 V et 1,7 V en valeur absolue, de préférence entre 0,5 V et 1,4 V, et le potentiel du drain peut être compris entre 0,85 V et 2,2 V en valeur absolue, de préférence entre 1 V et 2 V.

La source du transistor est soumise à un potentiel de référence lors de l'application des potentiels de grille et de drain. Ce potentiel de référence est de préférence nul.

L'invention concerne également un dispositif mémoire capable de mettre en œuvre le procédé de programmation décrit ci-dessus. Ce dispositif mémoire comporte :
- au moins une cellule mémoire DRAM à un transistor, comprenant une source et un drain dopés d'un premier type de conductivité, une région de corps disposée entre la source et le drain, et une grille isolée disposée en regard de la région de corps, la région de corps comportant des première et deuxième portions s'étendant parallèlement à la grille isolée entre la source et le drain, la première portion étant dopée d'un second type de conductivité opposé et disposée entre la grille isolée et la deuxième portion, dopée du premier type de conductivité ;
- un circuit d'alimentation ; et
- un circuit de polarisation reliant le circuit d'alimentation au drain et à la grille de la cellule mémoire.

Ce dispositif mémoire est remarquable en ce que le circuit d'alimentation est configuré pour fournir au drain et à la grille, lors d'une programmation de la cellule mémoire, des potentiels de drain et de grille choisis de manière à polariser le transistor dans un état bloqué et à créer des porteurs de charge par ionisation par impact dans la deuxième portion.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 représente schématiquement une cellule de mémoire dynamique à un transistor de type A2RAM ;
- les figures 2A et 2B illustrent deux modes de programmation de la cellule mémoire A2RAM selon l'art antérieur ;
- les figures 3A à 3C illustrent de manière schématique le comportement de la cellule mémoire A2RAM de la figure 1 lors d'un procédé de programmation selon un mode de mise en œuvre de l'invention ;
- la figure 4 représente le courant de lecture de la cellule mémoire A2RAM programmée dans l'état '1' en fonction du potentiel de grille appliqué lors de la programmation, pour plusieurs valeurs du potentiel de drain appliqué lors de la programmation ;
- les figures 5A et 5B représentent le taux d'ionisation par impact dans la cellule mémoire A2RAM lors de sa programmation, pour deux valeurs différentes du potentiel de grille ;
- la figure 6 représente le ratio du courant de lecture de la cellule mémoire dans l'état '1' sur le courant de lecture de la cellule dans l'état '0', en fonction du potentiel de grille et du potentiel de drain appliqués lors de la programmation ; et
- la figure 7 illustre un mode de réalisation d'un dispositif mémoire capable de mettre en œuvre le procédé de programmation selon l'invention.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

Le procédé de programmation décrit ci-après est destiné à une cellule de mémoire dynamique à un transistor de type A2RAM, par exemple celle représentée par la figure 1. Comme indiqué précédemment, la cellule mémoire A2RAM comporte :
- une région de source 3 et une région de drain 4 en un matériau semi-conducteur dopé d'un premier type de conductivité ;
- une région de corps semi-conducteur 5 disposée entre les régions de source 3 et de drain 4 ; et
- une région de grille 8 disposée en regard de la région de corps 5 et isolée électriquement de celle-ci par au moins une couche diélectrique 10.

Dans un souci de simplicité, les régions de source 3, de drain 4 et de grille 8 du transistor seront dorénavant désignés par les termes « source », « drain » et « grille » respectivement.

La région de corps 5 du transistor comporte une première portion 5a, parfois appelée « région de canal » (car le canal de conduction du transistor est susceptible de s'y former) ou « région de corps supérieure », et une deuxième portion 5b, appelée communément « pont conducteur » ou « région de corps inférieure ». Ces deux portions 5a-5b s'étendent parallèlement à la grille 8 entre la source 3 et le drain 4 du transistor. La première portion 5a, disposée entre la grille 8 et la deuxième portion 5b, est dopée d'un second type de conductivité opposé au premier type de conductivité. La deuxième portion 5b, la plus éloignée de la grille 8, est dopée du premier type de conductivité.

Les deux portions 5a-5b sont en outre, dans l'exemple de la figure 1, en contact l'une de l'autre et superposées sur une couche de base, par exemple la couche d'oxyde enterrée 1 d'un substrat 2 de type SOI.

Le transistor de la cellule mémoire est par exemple un transistor NMOS. La source 3, le drain 4 et le pont conducteur 5b sont alors tous dopés de type N, tandis que la région de canal 5a est dopée de type P.

La source 3 et le drain 4 sont respectivement en contact avec des métallisations de source 6 et de drain 7, reliées respectivement à des bornes de source S et de drain D. La grille 8 est reliée à une borne de grille G par l'intermédiaire d'une métallisation de grille 9. Les bornes de source S, de drain D et de grille G permettent d'appliquer des potentiels électriques, respectivement à la source 3, au drain 4 et à la grille 8, afin de polariser le transistor lors des phases d'écriture, de maintien et de lecture de la cellule mémoire.

De manière classique pour une cellule de mémoire vive dynamique, la cellule mémoire A2RAM peut prendre les états logiques « 0 » et « 1 » en fonction du nombre de charges stockées dans la région de corps 5 du transistor, et plus particulièrement dans la région de canal 5a. Par convention, l'état '1' correspond à la présence de porteurs de charge majoritaires dans la région de canal 5a, alors que l'état '0' correspond à l'absence de porteurs de charge majoritaires dans cette région. Ainsi, l'état '0' et l'état '1' de la cellule mémoire pourront également être appelés « état déchargé » et « état chargé ».

Les inventeurs ont constaté qu'en polarisant le transistor NMOS dans l'état bloqué, avec un potentiel de grille négatif plus élevé (ou plus faible en valeur absolue) que celui utilisé pour la programmation classique par effet tunnel bande à bande, la cellule mémoire A2RAM pouvait être programmée bien plus rapidement dans l'état logique '1' sans augmenter de manière significative la consommation électrique de la cellule. Ce constat est pour le moins surprenant car l'effet tunnel bande à bande est connu pour s'amplifier lorsqu'on augmente (en valeur absolue) la tension V_{DG} entre le drain 4 et la grille 8, soit dans le cas du transistor NMOS en augmentant le potentiel (positif) V_{D} du drain 3 et/ou en diminuant le potentiel (négatif) V_{G} de la grille 8. Ainsi, en augmentant le potentiel (négatif) V_{G} de la grille, on devrait s'attendre à une diminution du taux de génération des porteurs de charge par effet tunnel bande à bande, et par conséquent à une diminution de la vitesse de programmation.

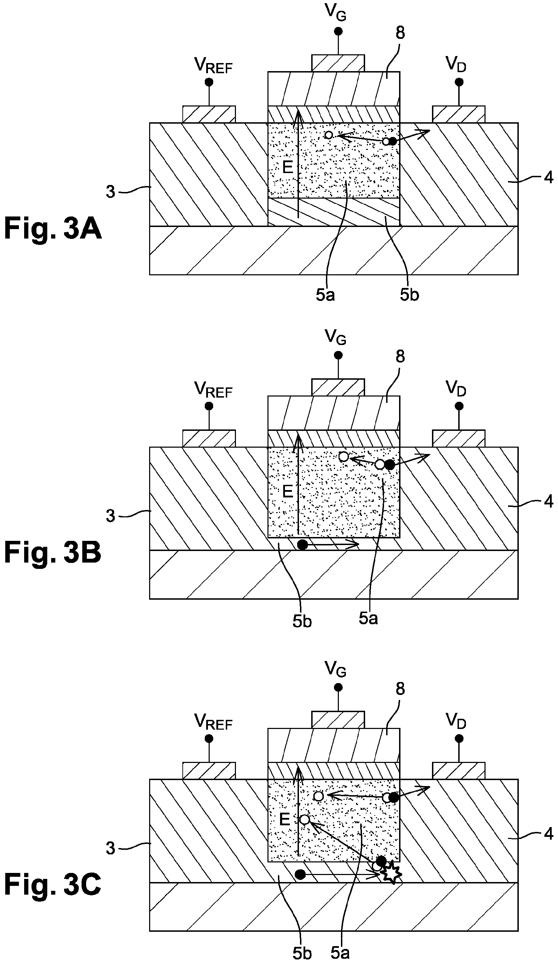

Pour expliquer les mécanismes à l'origine de cette vitesse de programmation élevée de l'état '1', le comportement de la cellule mémoire A2RAM lors du procédé de programmation selon l'invention a été artificiellement découpé en trois phases successives, illustrées par les figures 3A à 3C. Les potentiels V_{D} et V_{G} appliqués respectivement sur le drain 4 et la grille 8 du transistor NMOS sont de l'ordre de 1 V ou 2 V en valeurs absolues et ne varient pas au cours de la programmation. Par ailleurs, la source 3 du transistor est connectée à un potentiel de référence V_{REF} pendant la programmation. Ce potentiel de référence est de préférence nul (autrement dit la source 3 est reliée à la masse). Alternativement, la source 3 peut être soumise à un potentiel V_{REF} faiblement négatif, de l'ordre de -0,2 V.

La première phase, illustrée par la figure 3A, est marquée par la génération d'un petit nombre de porteurs de charge, par effet tunnel bande à bande (ci-après « BTB ») entre le drain 4 et la région de canal 5a du transistor NMOS. Le taux de génération des porteurs de charge par BTB est fixé par la tension V_{DG} entre le drain 4 et la grille 8 (V_{DG} = V_{D} - V_{G}). Comme les potentiels de grille V_{G} et de drain V_{D} sont faibles, ce taux de génération est faible. Les trous, provenant de la bande de conduction du drain 4, se déplacent sous l'effet du champ électrique grille-drain en direction de la grille 8 et sont stockés dans la région de canal 5a. Par ailleurs, le champ électrique vertical E généré par la grille 8 coupe électrostatiquement le pont conducteur 5b. Par conséquent, aucun courant ne circule entre la source 3 et le drain 4 via le pont conducteur 5b. On notera que, lors de cette première phase, la faible quantité de trous stockés dans la région de canal 5a n'a aucune influence sur le champ électrique vertical E perçu par le pont conducteur 5b sous-jacent.

Lors de la deuxième phase (cf. Fig.3B), les trous générés par BTB continue de s'accumuler dans la région de canal 5a et leur nombre devient suffisant pour écranter partiellement le champ électrique vertical E. Le pont conducteur 5b devient alors moins dépeuplé et un faible courant d'électrons circule dans le pont conducteur 5b entre la source 3 et le drain 4.

Lors de la troisième et dernière phase (cf. Fig.3C), les trous stockés dans la région de canal 5a sont en nombre suffisant pour écranter totalement le champ électrique vertical E. Le courant qui circule dans le pont conducteur 5b est alors maximum (aux valeurs de V_{S} et V_{D} considérées). Le champ électrique source-drain donne suffisamment de vitesse aux électrons pour que ceux-ci créent, par collision avec des atomes du pont conducteur 5b, des paires électron-trou. Les trous générés par ces collisions ou impacts sont attirés vers la grille 8 et augmentent de façon significative la charge électrique stockée dans la région de canal 5a.

Compte tenu que le potentiel de grille est relativement faible, le champ électrique vertical E est rapidement écranté. Autrement dit, peu de trous générés par BTB sont nécessaires pour observer la circulation d'un courant dans le pont conducteur 5b. L'ionisation par impact dans le pont conducteur 5b est donc le mécanisme dominant de génération de trous dans ce procédé de programmation.

Ainsi, la rapidité avec laquelle l'état '1' est programmé, ou écrit, s'explique par une génération importante de porteurs de charge dans le pont conducteur 5b via le mécanisme d'ionisation par impact.

Pour un potentiel de grille particulièrement faible, de l'ordre de -1 V, le champ électrique vertical E est tel que les première et deuxième phases sont négligeables (en termes de nombre de trous générés). En effet, dans ces conditions, un courant circule dans le pont conducteur 5b dès le début de la programmation, de sorte que les trous stockés dans la région de canal 5a sont essentiellement générés par le mécanisme d'ionisation par impact dans le pont conducteur 5b.

Puisque la vitesse de programmation (i.e. la vitesse de génération des porteurs de charge) est élevée, les potentiels de grille V_{G} et de drain V_{D} n'ont pas besoin d'être appliqués pendant de longues périodes pour programmer la cellule dans l'état '1'. De préférence, le potentiel de grille V_{G} est appliqué pendant une première durée comprise entre 0,1 ns et 10 ns et le potentiel de drain V_{D} est appliqué pendant une deuxième durée supérieure ou égale à la première durée. De préférence, la deuxième durée est également comprise entre 0,1 ns et 10 ns.

De préférence, les potentiels V_{G} et V_{D} ont la forme d'impulsions rectangulaires. Ainsi, par « durée d'application » du potentiel de grille ou de drain, on entend la largeur des impulsions de grille ou de drain. Le temps de programmation de la cellule mémoire correspond à la durée pendant laquelle le potentiel de grille V_{G} est appliqué, soit la plus petite largeur d'impulsion.

Des simulations électriques TCAD (pour « Technology Computer Aided Design » en anglais) ont été effectuées avec la structure de mémoire A2RAM représentée sur la figure 1, afin de déterminer les potentiels de grille V_{G} et de drain V_{D} à appliquer pour obtenir un taux élevé d'ionisation par impact dans le pont conducteur 5b, compte tenu des paramètres technologiques de la cellule.

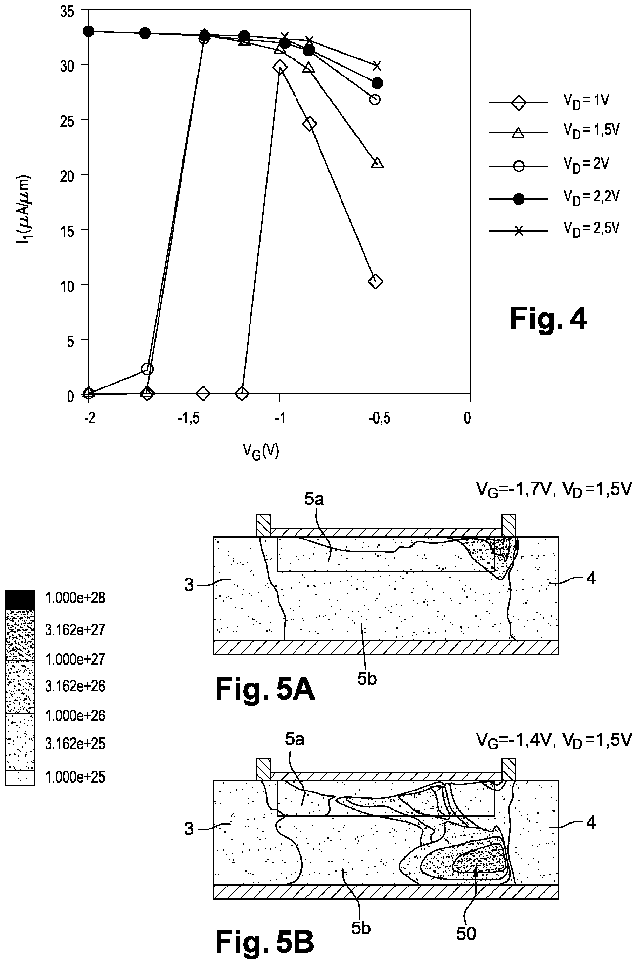

La figure 4 représente le courant de lecture I₁ mesuré dans la cellule mémoire après que celle-ci ait été programmée dans l'état '1', en fonction des potentiels de grille V_{G} et de drain V_{D} ayant servi pour la programmation. Ces potentiels déterminent la quantité de charges stockées dans la région de canal 5a. Plus les charges stockées dans la région de canal 5a sont nombreuses, moins le pont conducteur 5b est résistif lors de la lecture de la cellule mémoire et plus le courant de lecture I₁ est élevé. Un courant I₁ élevé est donc synonyme d'une région de canal 5a fortement chargée, autrement dit d'une programmation marquée et durable de l'état '1'. Les paramètres technologiques de la cellule mémoire sont les suivants :
- longueur de grille L_{G} (distance séparant la source et le drain) : L_{G} = 80 nm ;
- épaisseur de la région de canal 5a : t_{channel} = 14 nm ;
- épaisseur du pont conducteur 5b : t_{bridge} = 22 nm ;
- épaisseur de la couche diélectrique 10 (oxyde de grille) : 3,1 nm ;
- épaisseur de la couche d'oxyde enterrée 1 : 10 nm ;
- matériau semi-conducteur composant la source 3, le drain 4 et la région de corps 5 : silicium (Si) ;
- matériau de la couche diélectrique 10 (oxyde de grille) et de la couche d'oxyde enterrée : dioxyde de silicium (SiO₂) ;
- dopage de la source 3 et du drain 4 (type N) : 10²⁰ cm⁻³ ;
- dopage de la région de canal 5a (type P) : 10¹⁵ cm⁻³ ; et
- dopage du pont conducteur 5b (type N) : 10¹⁸ cm⁻³.

Pour ces simulations, le temps de programmation est choisie excessivement long (de l'ordre de 1 µs) afin de charger entièrement la région de canal 5a, quelle que soit les potentiels de drain et de grille appliqués (et donc les mécanismes de génération mis en jeu).

Pour chaque valeur du potentiel de drain V_{D} comprise entre 1 V et 2 V (bornes incluses), on constate une brusque augmentation du courant de lecture I₁ lorsqu'on diminue (en valeur absolue) le potentiel de grille V_{G} en deçà d'un certain seuil (ledit seuil étant fonction du potentiel de drain V_{D}). Par exemple, pour un potentiel de drain V_{D} égal à 1,5 V, le courant de lecture I₁ est quasiment nul lorsque le potentiel de grille V_{G} vaut -1,7 V alors qu'il atteint son maximum pour V_{G} = -1,4 V.

Comme indiqué précédemment, cette augmentation du courant de lecture I₁ (lorsque V_{G} diminue en valeur absolue) est contradictoire avec le comportement électrique observé lors d'une programmation classique par BTB, ce comportement étant illustré sur la figure 4 par les courbes à V_{D} = 2,2 V et V_{D} = 2,5 V. En BTB, le courant de lecture I₁ tend en effet à diminuer lorsqu'on diminue en valeur absolue le potentiel de grille V_{G} appliqué lors de la programmation, pour un potentiel de drain V_{D} donné. L'augmentation du courant de lecture I₁, visible pour certaines valeurs de potentiel de drain V_{D} (de 1 V à 2 V dans le cas de la figure 4), permet donc de mettre en évidence qu'un nouveau mécanisme de génération de porteurs de charge (autre que l'effet tunnel bande à bande) gouverne la programmation de l'état '1'.

Les figures 5a et 5B, également obtenues par simulation électrique, montrent le taux d'ionisation par impact dans la structure de mémoire A2RAM, respectivement lors d'une programmation à V_{G} = -1,7 V et V_{D} = 1,5 V et d'une programmation à V_{G} = -1,4 V et V_{D} = 1,5 V. À V_{G} = -1,4 V (Fig.5b), on constate un fort taux d'ionisation par impact dans une région 50 du pont conducteur 5b proche du drain 4. Cela implique qu'un courant élevé circule dans le pont conducteur 5b, de la source 3 vers le drain 4. À l'inverse, à V_{G} = -1,7 V, il n'y a pratiquement pas d'ionisations par impact dans le pont conducteur 5b, car le champ électrique vertical E, trop fort, coupe électrostatiquement le pont conducteur 5b.

Les valeurs du potentiel de grille V_{G} à appliquer pour programmer efficacement la cellule mémoire avec ce nouveau mécanisme sont celles pour lequel le courant I₁ est élevé, en l'occurrence celles en dessous du seuil susmentionné (par exemple de V_{G} = -1,4 V à V_{G} = -0,5 V pour V_{D} = 1,5 V et V_{D} = 2 V).

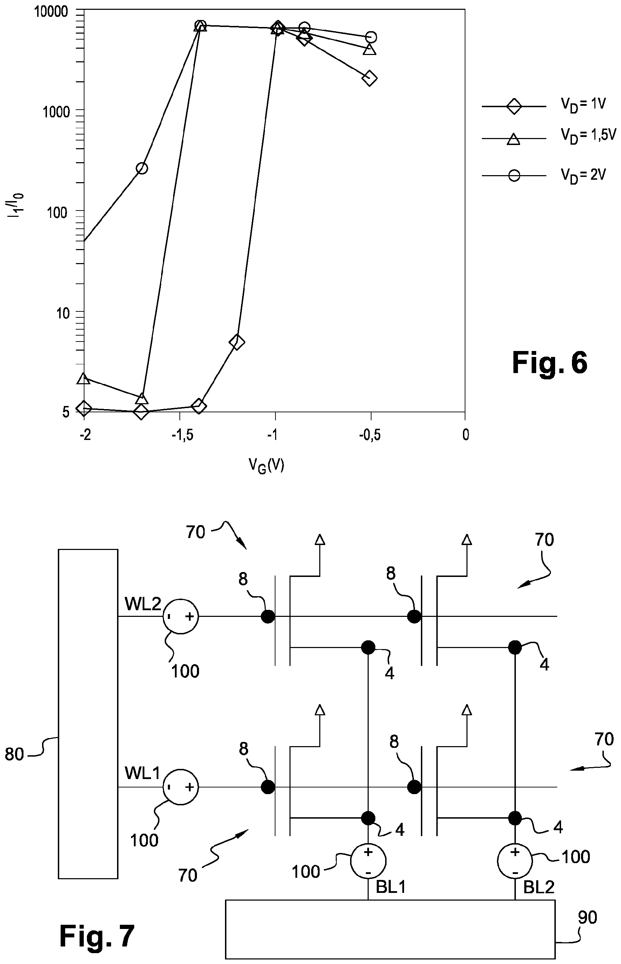

La figure 6 montre que, pour ces mêmes valeurs de potentiels, le ratio du courant I₁ sur le courant I₀ mesuré lors de la lecture de la cellule mémoire à l'état '0' est bien supérieur à 1000. Ainsi, en plus d'être rapide, le procédé de programmation selon l'invention garantit une large fenêtre de programmation. Les états logiques '0' et '1' de la cellule mémoire peuvent donc être distingués facilement.

Le procédé de programmation selon l'invention a également pour avantage de ne pas causer de dommages dans la cellule mémoire A2RAM, contrairement au mode de programmation classique par ionisation par impact. Ici, l'ionisation par impact a lieu dans la portion du corps la plus éloignée de la grille. Des porteurs de charge fortement énergétiques ne risquent donc pas d'être piégés dans l'oxyde de grille. La fiabilité et la rétention de la cellule mémoire A2RAM ne sont donc pas impactées par les programmations successives.

Le tableau ci-après donne, pour la configuration de cellule mémoire décrite ci-dessus (configuration n° 1) et d'autres configurations listées en dessous, les valeurs de potentiels de grille V_{G} et de drain V_{D} pour lesquelles le mécanisme d'ionisation par impact a lieu dans le pont conducteur 5b et qui, par conséquent, résultent en une programmation rapide de l'état '1'. Ces valeurs ont été déterminées grâce à des simulations TCAD en prenant comme critères :
- un courant de lecture de l'état '1' suffisamment élevé pour être détecté par les circuits périphériques de la mémoire (typiquement les amplificateurs), par exemple I₁ ≥ 6 µA/µm ;
- une fenêtre de programmation telle que I₁/I₀ ≥ 20 (I₀ étant le courant de lecture de la cellule mémoire dans l'état '0') ;

| **Configuration** | **V_{D} (en V)** | **V_{G} (en V)** |
|---|---|---|
| **n° 1** (L_{G} = 80 nm ; t_{channel} = 10 nm ; t_{bridge} = 18 nm...) | 2/1,5 | -1,4 à -0,5 |
| | 1 | -1 à -0,5 |
| **n° 2** (t_{channel} = 10 nm) | 2,2/2 | -1,2 à -0,5 |
| | 1,5 | -1 à -0,5 |
| | 1 | -0,85 |
| **n° 3** (t_{bridge} = 18 nm) | 2,2 | -1,2 à -0,5 |
| | 2 | -1 à -0,5 |
| | 1,5 | -0,85 à -0,5 |
| **n° 4** (L_{G} = 60 nm) | 1 | -1,7 à -0,85 |
| | 0,85 | -1,2 à -0,5 |
| **n° 5** (L_{G} = 70 nm) | 1,5 | -1,7 à -0,5 |
| | 1 | -1,4 à -0,5 |
| | 0,85 | -1,2 à -0,5 |

La configuration n°2 diffère de la configuration n°1 en ce que l'épaisseur t_{channel} de la région de canal 5a est de 10 nm, au lieu de 14 nm.

La configuration n°3 diffère de la configuration n°1 en ce que l'épaisseur t_{bridge} du pont conducteur 5b est de 18 nm, au lieu de 22 nm.

La configuration n°4 diffère de la configuration n°1 en ce que la longueur de grille L_{G} est de 60 nm, au lieu de 80 nm.

La configuration n°5 diffère de la configuration n°1 en ce que la longueur de grille L_{G} est de 70 nm, au lieu de 80 nm.

Naturellement, le procédé de programmation selon l'invention n'est pas limité à la structure de cellule mémoire représentée sur la figure 1, ni aux configurations de paramètres technologiques donnés ci-dessus à titre d'exemple. En particulier, le procédé de programmation est applicable aux structures de cellule mémoire A2RAM décrites dans le brevet EP2764550. Les potentiels de drain et de grille pourront être déterminés pour toute autre structure et/ou configuration, de préférence au moyen de simulations électriques de type TCAD telles que celles représentées par les figures 4, 5A-5B et 6.

Par ailleurs, le procédé de programmation s'applique aussi bien à des cellules de mémoire A2RAM comprenant un transistor NMOS qu'aux cellules de mémoire A2RAM comprenant un transistor PMOS. Dans le cas d'un transistor PMOS (i.e. drain, source et pont conducteur de type P, région de canal de type N), les potentiels de grille, de drain et de source seront simplement de signe opposé à ceux donnés ci-dessus dans le cas du transistor NMOS.

La figure 7 représente schématiquement un dispositif mémoire dans lequel le procédé de programmation selon l'invention peut être mis en œuvre. Ce dispositif mémoire comporte au moins une cellule mémoire 70 de type A2RAM, telle que décrite en relation avec la figure 1, et de préférence une pluralité de cellules mémoire 70 identiques organisées en lignes et en colonnes sous la forme d'une matrice. À titre d'illustration, le dispositif mémoire de la figure 7 comprend quatre cellules mémoire 70 réparties en deux lignes et deux colonnes.

En outre, le dispositif mémoire comporte respectivement autant de lignes de mot WL (ou « wordline » en anglais) et de lignes de bit BL (ou « bitline ») que la matrice de cellules mémoire possède de lignes et de colonnes. Chaque ligne de mot WL relie les grilles 8 des cellules mémoire 70 appartenant à une même ligne de la matrice tandis que chaque ligne de bit BL relie les drains 4 des cellules mémoire 70 appartenant à une même colonne. Chaque cellule mémoire 70 se situe ainsi au croisement d'une ligne de bit BL et d'une ligne de mot WL.

Les différentes lignes de mot WL (WL1, WL2,...) du dispositif mémoire sont par ailleurs connectées à un premier circuit d'adressage 80, tandis que les différentes lignes de bit BL (BL1, BL2,...) sont connectées à un deuxième circuit d'adressage 90.

Les circuits d'adressage 80-90 et les lignes de mot WL et de bit BL forment ensemble un circuit de polarisation des cellules mémoire. Ce circuit de polarisation est couplé à un circuit d'alimentation, composé d'une pluralité de sources de tension 100. Les sources de tension 100 sont programmables, afin de moduler le potentiel délivré en fonction de l'opération à effectuer (lecture, écriture, maintien...). Les potentiels électriques délivrés par ces sources de tension 100 sont choisis pour mettre en œuvre le procédé de programmation selon l'invention. Chaque ligne de bit BL ou de mot WL peut être connectée à une source de tension 100 dédiée. Les potentiels peuvent donc être acheminés jusqu'aux drains 4 et grilles 8 des cellules, par les lignes de bit BL et de mot WL respectivement.

Enfin, le dispositif mémoire comporte un contrôleur (non représenté) configuré pour déclencher une programmation dans l'état '1' de l'une des cellules mémoire 70. Ce contrôleur envoie des signaux de commande aux circuits d'adressage 80-90 afin qu'ils sélectionnent les lignes de bit BL et de mot WL correspondant à la cellule à programmer. En réponse à ces signaux de commande, les circuits d'adressage 80-90 connectent les lignes de bit BL et de mot WL sélectionnées aux sources de tension 100 correspondantes.

En plus d'activer la ligne de bit WL correspondant à la cellule à programmer, le deuxième circuit d'adressage 90 est capable de lire et d'amplifier le courant de drain de la cellule mémoire sélectionnée.

## Revendications

1. Procédé de programmation d'une cellule mémoire DRAM à un transistor, la cellule mémoire comprenant une source (3) et un drain (4) dopés d'un premier type de conductivité, une région de corps (5) disposée entre la source et le drain, et une grille isolée (8) disposée en regard de la région de corps (5), la région de corps comportant des première et deuxième portions (5a, 5b), les première et deuxième portions (5a, 5b) s'étendant parallèlement à la grille isolée (8) entre la source (3) et le drain (4), la première portion (5a) étant dopée d'un second type de conductivité opposé et disposée entre la grille isolée (8) et la deuxième portion (5b), dopée du premier type de conductivité, le procédé de programmation comprenant une étape de polarisation du transistor dans un état bloqué au moyen de potentiels électriques (V_{D}, V_{G}) appliqués sur le drain (4) et la grille (8),
**caractérisé en ce que** le potentiel du drain (V_{D}) et le potentiel de la grille (V_{G}) sont choisis de manière à créer des porteurs de charge par ionisation par impact dans la deuxième portion (5b).

2. Procédé selon la revendication 1, dans lequel le potentiel de la grille (V_{G}) est appliqué pendant une première durée comprise entre 0,1 ns et 10 ns et dans lequel le potentiel du drain (V_{D}) est appliqué pendant une deuxième durée supérieure ou égale à la première durée, et de préférence comprise entre 0,1 ns et 10 ns.

3. Procédé selon l'une des revendications 1 et 2, dans lequel le potentiel de la grille (V_{G}) est compris entre 0,5 V et 1,7 V en valeur absolue, de préférence entre 0,5 V et 1,4 V, et dans lequel le potentiel du drain (V_{D}) est compris entre 2,2 V et 0,85 V en valeur absolue, de préférence entre 1 V et 2 V.

4. Procédé selon l'une quelconque des revendications 1 à 3, dans lequel la source (3) du transistor est soumise à un potentiel de référence (V_{REF}), de préférence nul.

5. Dispositif mémoire comportant :
- au moins une cellule mémoire DRAM (70) à un transistor, comprenant une source (3) et un drain (4) dopés d'un premier type de conductivité, une région de corps (5) disposée entre la source et le drain, et une grille isolée (8) disposée en regard de la région de corps (5), la région de corps comportant des première et deuxième portions (5a, 5b), les première et deuxième portions (5a, 5b) s'étendant parallèlement à la grille isolée (8) entre la source (3) et le drain (4), la première portion (5a) étant dopée d'un second type de conductivité opposé et disposée entre la grille isolée (8) et la deuxième portion (5b), dopée du premier type de conductivité ;
- un circuit d'alimentation (100) ; et
- un circuit de polarisation (BL1, WL1) reliant le circuit d'alimentation (100) au drain (4) et à la grille (8) de la cellule mémoire ;
**caractérisé en ce que** le circuit d'alimentation (100) est configuré pour fournir au drain et à la grille, lors d'une programmation de la cellule mémoire (70), des potentiels de drain (V_{D}) et de grille (V_{G}) choisis de manière à polariser le transistor dans un état bloqué et à créer des porteurs de charge par ionisation par impact dans la deuxième portion (5b).

## Patentansprüche

1. Programmierverfahren einer DRAM-Speicherzelle mit einem Transistor, wobei die Speicherzelle eine Source (3) und ein Drain (4) umfasst, die mit einem ersten Leitfähigkeitstyp, einer Körperregion (5), die zwischen der Source und dem Drain angeordnet ist, und einem isolierten Gitter (8), das gegenüber der Körperregion (5) angeordnet ist, dotiert ist, wobei die Körperregion erste und zweite Abschnitte (5a, 5b) umfasst, wobei sich der erste und der zweite Abschnitt (5a, 5b) parallel zum isolierten Gitter (8) zwischen der Source (3) und dem Drain (4) erstrecken, wobei der erste Abschnitt (5a) mit einem zweiten, entgegengesetzten Leitfähigkeitstyp dotiert ist und zwischen dem isolierten Gitter (8) und dem zweiten Abschnitt (5b) angeordnet ist, der mit dem ersten Leitfähigkeitstyp dotiert ist, wobei das Programmierverfahren einen Polarisationsschritt des Transistors in einem blockierten Zustand mittels elektrischer Potenziale (V_{D}, V_{G}) umfasst, die auf das Drain (4) und das Gitter (8) angewendet werden,
**dadurch gekennzeichnet, dass** das Potenzial des Drains (V_{D}) und das Potenzial des Gitters (V_{G}) derartig ausgewählt sind, dass Lastenträger per Ionisierung per Aufprall in dem zweiten Abschnitt (5b) geschaffen werden.

2. Verfahren gemäß Anspruch 1, in dem das Potenzial des Gitters (V_{G}) während einer ersten Dauer, die zwischen 0,1 ns und 10 ns inbegriffen ist und bei der das Potenzial des Drains (V_{D}) während einer zweiten Dauer angewendet wird, die größer als oder gleich der ersten Dauer ist und bevorzugt zwischen 0,1 ns und 10 ns inbegriffen ist, angewendet wird.

3. Verfahren gemäß einem der Ansprüche 1 und 2, bei dem das Potenzial des Gitters (V_{G}) zwischen 0,5 V und 1,7 V als absoluten Wert, bevorzugt zwischen 0,5 V und 1,4 V, inbegriffen ist und bei dem das Potenzial des Drains (V_{D}) zwischen 2,2 V und 0,85 V als absoluten Wert, bevorzugt zwischen 1 V und 2 V, inbegriffen ist.

4. Verfahren gemäß irgendeinem der Ansprüche 1 bis 3, bei dem die Source (3) des Transistors einem Referenzpotenzial (V_{REF}), bevorzugt null, unterworfen wird.

5. Speicherverfahren, umfassend:
- wenigstens eine DRAM-Speicherzelle (70) mit einem Transistor, umfassend eine Source (3) und ein Drain (4), die mit einem ersten Leitungstyp, einer Körperregion (5), die zwischen der Source und dem Drain angeordnet ist, und einem isolierten Gitter (8), das gegenüber der Körperregion (5) angeordnet ist, dotiert sind, wobei die Körperregion erste und zweite Abschnitte (5a, 5b) umfassen, wobei sich der erste und der zweite Abschnitt (5a, 5b) parallel zum isolierten Gitter (8) zwischen der Source (3) und dem Drain (4) erstrecken, wobei der erste Abschnitt (5a) mit einem zweiten entgegengesetzter Leitungstyp dotiert ist, und der zwischen dem isolierten Gitter (8) und dem zweiten Abschnitt (5b), der mit dem ersten Leitungstyp dotiert ist, angeordnet ist;
- eine Versorgungsschaltung (100); und
- eine Polarisationsschaltung (BL1, WL1), die die Versorgungsschaltung (100) mit dem Drain (4) und dem Gitter (8) der Speicherzelle verbindet;
**dadurch gekennzeichnet, dass** die Versorgungsschaltung (100) ausgestaltet ist, um dem Drain und dem Gitter bei einer Programmierung der Speicherzelle (70) Drain- (V_{D}) und Gitterpotenziale (V_{G}) zu liefern, die derart ausgewählt sind, dass der Transistor in einem blockierten Zustand polarisiert ist und Lastenträger per Ionisierung per Aufprall in dem zweiten Abschnitt (5b) geschaffen sind.

## Claims

1. Method for programming a one-transistor DRAM memory cell, the memory cell comprising a source (3) and a drain (4) doped of a first conductivity type, a body region (5) arranged between the source and the drain, and an insulated gate (8) arranged facing the body region (5), the body region comprising first and second portions (5a, 5b), the first and second portions (5a, 5b) extending parallel to the insulated gate (8) between the source (3) and the drain (4), the first portion (5a) being doped of a second conductivity type opposite to the first conductivity type and arranged between the insulated gate (8) and the second portion (5b), doped of the first conductivity type, the programming method comprising a step of biasing the transistor in an off state by means of electrical potentials (V_{D}, V_{G}) applied to the drain (4) and the gate (8),
**characterised in that** the drain potential (V_{D}) and the gate potential (V_{G}) are chosen in such a way as to create charge carriers by impact ionisation in the second portion (5b).

2. Method according to claim 1, wherein the gate potential (V_{G}) is applied for a first duration comprised between 0.1 ns and 10 ns and wherein the drain potential (V_{D}) is applied for a second duration greater than or equal to the first duration, and preferably comprised between 0.1 ns and 10 ns.

3. Method according to one of claims 1 and 2, wherein the gate potential (V_{G}) is comprised between 0.5 V and 1.7 V in absolute value, preferably between 0.5 V and 1.4 V, and wherein the drain potential (V_{D}) is comprised between 2.2 V and 0.85 V in absolute value, preferably between 1 V and 2 V.

4. Method according to any of claims 1 to 3, wherein the source (3) of the transistor is subjected to a reference potential (V_{REF}), preferably zero.

5. Memory device comprising:
- at least one one-transistor DRAM memory cell (70) comprising a source (3) and a drain (4) doped of a first conductivity type, a body region (5) arranged between the source and the drain, and an insulated gate (8) arranged facing the body region (5), the body region comprising first and second portions (5a, 5b), the first and second portions (5a, 5b) extending parallel to the insulated gate (8) between the source (3) and the drain (4), the first portion (5a) being doped of a second conductivity type opposite to the first conductivity type and arranged between the insulated gate (8) and the second portion (5b), doped of the first conductivity type;
- a supply circuit (100); and
- a bias circuit (BL1, WL1) connecting the supply circuit (100) to the drain (4) and to the gate (8) of the memory cell;
**characterised in that** the supply circuit (100) is configured to supply to the drain and to the gate, during programming of the memory cell (70), drain (V_{D}) and gate (V_{G}) potentials chosen in such a way as to bias the transistor in an off state and to create charge carriers by impact ionisation in the second portion (5b).
